# FASCICULE DE BREVET EUROPEEN

(11) **EP 2 773 173 B1**
(45) Date de publication et mention de la délivrance du brevet: **13.09.2017**
(21) Numéro de dépôt: 14154794.3
(22) Date de dépôt: 12.02.2014
(51) Int. Cl.: H05K 7/20

(54) **Système de refroidissement liquide pour armoire informatique**
Flüssigkühlsystem für IT-Rack-Gehäuse
Liquid cooling system for computer cabinet

(30) Priorité: 28.02.2013 FR 1351776
(43) Date de publication de la demande: 03.09.2014
(73) Titulaire: BULL SAS, 78340 Les Clayes sous Bois (FR)
(72) Inventeur: Bonnin, Jean-Christophe, 78120 Rambouillet (FR); Nadifi, Eimed, 78150 Le Chesnay (FR)
(74) Mandataire: Camus, Olivier Jean-Claude

(56) Documents cités:
- JP-A- H0 541 589
- JP-A- H08 219 615

## Description

### DOMAINE TECHNIQUE

La présente invention concerne un système de refroidissement liquide pour armoire informatique.

### ETAT DE LA TECHNIQUE ANTERIEUR

Dans de nombreuses applications, les processeurs avec leurs électroniques associés (par exemple, mémoire, disques durs, alimentations, etc) sont contenus dans des lames de calcul elles mêmes insérées dans des serveurs montables sur bâti empilés les uns au dessus des autres dans un rack ou armoire. Initialement, les composants électroniques de ces lames de calcul étaient refroidis par de l'air en mouvement dans les chemins de circulation d'air parallèles qui traversaient les lames de calcul à l'aide de moyens de mise en circulation de l'air de type ventilateurs. Cependant, dans des installations de type « fermes de serveurs » dans lesquelles il y a un grand nombre d'armoires informatiques disposées dans un petit espace, le refroidissement par de l'air n'est pas suffisant.

Des systèmes de refroidissement liquide ont donc été développés. Ces systèmes de refroidissement liquide comportent généralement essentiellement:
- des circuits hydrauliques remplis par un fluide caloporteur qui parcourent les armoires informatiques ;
- des moyens de mise en circulation du fluide caloporteur dans les circuits hydrauliques ; et
- des moyens de refroidissement permettant de refroidir le fluide caloporteur.

Généralement, les moyens de mise en circulation du fluide caloporteur et les moyens de refroidissement ne sont pas contenus dans les armoires informatiques car le risque de fuite du fluide caloporteur est très élevé, notamment du fait que la qualité de ce fluide caloporteur n'est pas contrôlée, et le risque d'encrassement des circuits hydrauliques est très élevé, puisque les canaux qui parcourent les armoires informatiques présentent un petit diamètre.

En outre, les systèmes de refroidissement existants sont très volumineux, ce qui pose surtout un problème d'encombrement dans les salles informatiques contenant ces armoires, puisque ces salles informatiques doivent contenir non seulement les armoires informatiques, mais aussi leur système de refroidissement.

En outre, en cas de panne ou de fuite, les systèmes de refroidissement de l'art antérieur doivent être arrêtés, et par conséquent les armoires informatiques correspondantes également.

### EXPOSE DE L'INVENTION

L'invention vise à remédier aux inconvénients de l'état de la technique en proposant un système de refroidissement liquide d'une armoire informatique qui peut fonctionner même en cas de panne ou de fuite et qui n'encombre pas la salle informatique dans laquelle se trouve l'armoire informatique.

Pour ce faire, est proposé selon un premier aspect de l'invention, une armoire informatique comportant :
- au moins un serveur montable sur bâti, le serveur montable sur bâti étant traversé par un circuit de refroidissement, le circuit de refroidissement étant parcouru par un fluide caloporteur, le circuit de refroidissement de l'armoire comportant une entrée et une sortie ;
- des moyens d'alimentation du circuit de refroidissement en fluide caloporteur, les moyens d'alimentation comportant :
   - deux modules de refroidissement, chaque module de refroidissement comportant :
      - Un circuit hydraulique primaire comportant une sortie apte à être reliée à l'entrée d'un réseau hydraulique client et une entrée apte à être reliée à la sortie du réseau hydraulique client ;
      - Un circuit hydraulique secondaire comportant une sortie reliée à l'entrée du circuit de refroidissement de l'armoire informatique et une entrée reliée à la sortie du circuit de refroidissement de l'armoire informatique ;
      - Un échangeur de chaleur apte à refroidir le fluide caloporteur traversant le circuit hydraulique secondaire par dissipation de chaleur à travers le circuit hydraulique primaire;
      - Une pompe apte à contrôler le débit du fluide caloporteur dans le circuit hydraulique secondaire;
      - Des moyens de commande aptes à commander la pompe;
   - Une unité centrale de commande reliée aux moyens de commande de chacun des modules de refroidissement;
   l'unité centrale de commande étant apte à activer un des modules de refroidissement pendant que l'autre module de refroidissement est inactif, le circuit hydraulique secondaire du module de refroidissement actif alimentant le circuit de refroidissement de façon à maintenir le fluide caloporteur à une pression différentielle constante entre la sortie et l'entrée du module de refroidissement.

Les modules de refroidissement permettent ainsi de fournir un débit constant en fluide caloporteur à chacune des lames de calcul inclues dans les serveurs montables sur bâti de l'armoire.

Dans ce document, on utilise les termes circuit hydraulique « primaire » pour désigner les circuits reliés au réseau hydraulique de l'infrastructure du client et circuit hydraulique « secondaire » pour désigner les circuits hydrauliques reliés au circuit de refroidissement de l'armoire informatique.

Ainsi, le dispositif de refroidissement de l'armoire selon l'invention comporte deux modules de refroidissement complètement identiques : un des modules de refroidissement est actif, tandis que l'autre module de refroidissement est inactif. Ainsi, si un des deux modules de refroidissement présente un disfonctionnement, le contrôleur général peut activer l'autre module de refroidissement, de sorte que l'armoire informatique est toujours refroidie par au moins un module de refroidissement. Ainsi, même en cas de panne ou de maintenance d'un des modules de refroidissement, l'armoire informatique peut continuer à fonctionner. Les modules de refroidissement sont démontables en cas de maintenance sans arrêter le refroidissement des serveurs.

Les modules de refroidissement permettent de réguler le fluide caloporteur en débit pour assurer un débit de fluide caloporteur constant aux serveurs, quel que soit leur nombre dans l'armoire, et en température, pour assurer une température constante en entrée de serveurs quel que soit leur dissipation. En outre, les modules de refroidissement sont aptes à détecter des pannes par la surveillance de capteurs de pression et de température grâce à des moyens de commande propre à chaque module de refroidissement. En outre, le fait de maintenir des vitesses constantes dans le circuit de refroidissement et dans le circuit hydraulique secondaire qui lui est relié, permet d'éviter les vibrations des circuits. Les objets hydrauliques du module de refroidissement sont optimisés, d'une part, en consommation de pertes de charge, afin de minimiser l'énergie hydraulique que la pompe doit fournir et en optimiser ainsi sa dimension et sa consommation électrique, d'autre part, en terme d'encombrement afin d'obtenir la meilleure compacité du module. Le dispositif de refroidissement selon l'invention permet de dissiper 80 kW.

L'armoire informatique selon l'invention peut également comporter une ou plusieurs des caractéristiques ci-après prises individuellement ou selon toutes les combinaisons techniquement possibles.

Avantageusement, l'entrée et la sortie du circuit hydraulique primaire de chaque module de refroidissement sont pourvus de connecteurs rapides anti-gouttes permettant de connecter et de déconnecter facilement le circuit hydraulique primaire au réseau hydraulique client.

Avantageusement, l'entrée et la sortie du circuit hydraulique secondaire de chaque module de refroidissement sont pourvus de connecteurs rapides anti-goutte permettant de connecter et de déconnecter facilement le circuit hydraulique secondaire au circuit de refroidissement.

Avantageusement, les circuits hydrauliques des modules de refroidissement sont reliés en parallèle.

Selon un mode de réalisation préférentiel, les deux modules de refroidissement sont placés dans une partie inférieure de l'armoire, le serveur montable sur bâti étant placé dans une partie supérieure. Dans ce document, on utilise le terme « partie inférieure » pour désigner une partie qui est située sous une autre partie de l'armoire, qui est désignée par le terme « partie supérieure », lorsque l'armoire est en fonctionnement. Le fait d'avoir les modules de refroidissement sous le serveur montable sur bâti permet d'éviter qu'en cas de fuite du fluide caloporteur dans un des modules de refroidissement, ce fluide caloporteur ne coule sur le serveur montable sur bâti.

Le fluide caloporteur dans le circuit de refroidissement présente de préférence une pression statique supérieure ou égale à 2 bars. Le fait de maintenir le fluide caloporteur sous pression permet à la pompe d'être protégée de tout risque de cavitation, et au système de refroidissement de l'armoire informatique de fonctionner y compris en cas de fuite.

Selon un mode de réalisation, chaque module de refroidissement comporte en outre au moins un capteur de température apte à mesurer la température en sortie du circuit hydraulique secondaire dudit module de refroidissement, le débit du fluide caloporteur du circuit hydraulique primaire étant maintenu à un débit choisi pour que la température en sortie du circuit hydraulique secondaire soit égale à une température seuil. On s'assure ainsi que la température en entrée du circuit de refroidissement qui traverse le serveur montable sur bâti soit constante et donc que le refroidissement des composants électroniques des lames de calcul inclues dans les serveurs montables sur bâti soit optimal.

Chaque module de refroidissement comporte de préférence trois capteurs de température situés au même endroit, ce qui permet de vérifier les mesures effectuées par chacun des trois capteurs de température.

Avantageusement, chaque module de refroidissement comporte en outre une voie de contournement agencée pour permettre au fluide caloporteur de contourner la pompe. Cette voie de contournement, également appelée « bypass », permet notamment de tester la pompe de chacun des modules de refroidissement sans avoir à brancher ledit module de refroidissement sur un circuit de refroidissement. En outre, cette voie de contournement permet de choisir la quantité de fluide caloporteur qui est injectée en sortie du module de refroidissement. Pour cela, la voie de contournement est de préférence équipée d'une vanne de régulation contrôlée par les moyens de commande dudit module de refroidissement, la vanne de régulation étant apte à contrôler la quantité de fluide qui est dirigée dans la voie de contournement. Le fait de doser la quantité de fluide qui traverse la pompe favorise la linéarité de la réponse en débit.

Avantageusement, le circuit hydraulique secondaire de chaque module de refroidissement comporte un clapet anti-retour en amont de l'échangeur. Le terme « amont » est utilisé en référence au sens de circulation du fluide caloporteur dans le circuit hydraulique secondaire. Le clapet anti-retour de chacun des deux modules de refroidissement les protège l'un l'autre d'une recirculation du fluide caloporteur en provenance du module de refroidissement actif à travers le module de refroidissement inactif.

Selon un mode de réalisation, chaque module de refroidissement comporte au moins un premier capteur de pression, les moyens de commande de chaque module de refroidissement étant reliés aux deux premiers capteurs de pression de chacun des deux modules de refroidissement. Le fait de relier les moyens de commande de chaque module de refroidissement à deux capteurs de pression qui sont situés dans des modules de refroidissement différents permet de simuler une redondance des mesures de pression sans avoir une redondance des capteurs de pression au sein d'un même module de refroidissement.

Le premier capteur de pression (P₀₋₁) de chaque module de refroidissement est de préférence situé en entrée de la pompe dudit module de pression.

Chaque module de refroidissement comporte en outre de préférence un second capteur de pression (P₁₋₁) situé en sortie du module de refroidissement. On peut ainsi contrôler le module de refroidissement actif de façon à ce que le débit fournit à chaque lame de calcul soit constant en contrôlant la vanne de régulation de façon à ce que la différence de pression entre la sortie et l'entrée du module de refroidissement soit constante et égale à une pression différentielle seuil..

Chaque module de refroidissement comporte en outre de préférence un troisième capteur de pression (P₂₋₁) en sortie de la pompe dudit module de refroidissement. Ce troisième capteur de pression permet de vérifier que la pompe fonctionne correctement dans le cas d'un module actif, et permet de vérifier la mesure de pression dans le cas d'un module inactif en comparant cette pression avec la pression P₀₋₂ de l'autre module, actif.

### BREVES DESCRIPTION DES FIGURES

D'autres caractéristiques et avantages de l'invention ressortiront à la lecture de la description détaillée qui suit, en référence aux figures annexées, qui illustrent :
- La figure 1, une représentation schématique d'une armoire informatique selon un mode de réalisation de l'invention ;
- La figure 2, une vue en perspective d'un module de refroidissement selon un mode de réalisation de l'invention.

Pour plus de clarté, les éléments identiques ou similaires sont repérés par des signes de références identiques sur l'ensemble des figures.

### DESCRIPTION DETAILLEE D'AU MOINS UN MODE DE REALISATION

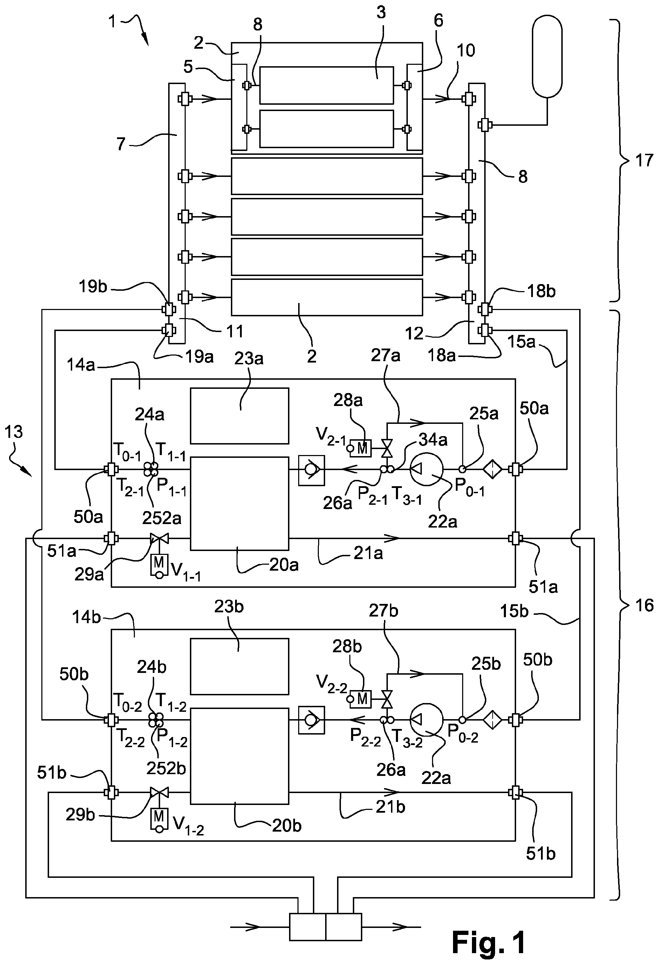

La figure 1 représente une armoire informatique 1 selon un mode de réalisation de l'invention. Cette armoire informatique 1 comporte un bâti dans lequel sont insérés des serveurs montables sur bâti 2. Dans ce mode de réalisation, l'armoire informatique 1 comporte cinq serveurs montables sur bâti 2. Le premier serveur montable sur bâti est détaillé sur la figure 1, et les autres serveurs montables sur bâti lui sont identiques. Chaque serveur montable sur bâti 2 comporte des lames de calcul 3. Chaque lame de calcul 3 comporte une carte électronique sur laquelle sont montés des composants électroniques, et notamment des processeurs ou des barrettes mémoires. Chaque lame de calcul 3 comporte des moyens de refroidissement liquide 10 qui permettent de refroidir la carte électronique et les composants électroniques. Pour cela, chaque moyen de refroidissement liquide comporte un canal qui est parcouru par un fluide caloporteur. Chaque moyen de refroidissement liquide 10 comporte de préférence une plaque froide disposée parallèlement à la carte électronique de ladite plaque froide de façon à la refroidir et à refroidir ses composants électroniques. Chaque serveur montable sur bâti 2 comporte également un manifold d'entrée 5 relié aux moyens de refroidissement 10 des lames de calcul 3 dudit serveur montable sur bâti de façon à répartir le fluide caloporteur entre ces différents moyens de refroidissement 10. Le serveur montable sur bâti 2 comporte également un manifold de sortie 6 relié aux moyens de refroidissement 10 des lames de calcul 3 dudit serveur montable sur bâti de façon à collecter le fluide caloporteur provenant des différents moyens de refroidissement des lames de calcul 3 dudit serveur montable sur bâti.

L'armoire informatique 1 comporte également une rampe de distribution d'entrée 7 reliée à chacun des manifolds d'entrée 5 de chaque serveur montable sur bâti 2 de façon à répartir le fluide caloporteur entre les différents manifolds d'entrée 5 des serveurs montables sur bâti 2. L'armoire informatique 1 comporte également une rampe de distribution de sortie 8 reliée à chacun des manifolds de sortie 6 de chaque serveur montable sur bâti 2 de façon à collecter le fluide caloporteur entre les différents manifolds de sortie 6 des serveurs montables sur bâti 2.

Les moyens de refroidissements 10 des lames de calcul 3 des serveurs montables sur bâti 2, les manifolds d'entrée 5 et de sortie 6 et les rampes de distribution d'entrée 7 et de sortie forment un circuit de refroidissement 10 qui permet de refroidir les composants électroniques des lames de calcul 3. Ce circuit de refroidissement 10 comporte une entrée 11 formée ici par la rampe de distribution d'entrée 7 et une sortie 12formée ici par la rampe de distribution de sortie 8.

L'armoire informatique 1 comporte également des moyens d'alimentation 13 du circuit de refroidissement en fluide caloporteur. Les moyens d'alimentation 13 sont situés dans une partie inférieure 16 de l'armoire informatique, tandis que les serveurs montables sur bâti 2 sont situés dans une partie haute de l'armoire informatique. Ainsi, en cas de fuite du fluide caloporteur, ce dernier ne s'écoule pas sur les serveurs montable sur bâti par gravité.

Les moyens d'alimentation 13 comportent deux modules de refroidissement 14a et 14b. Les deux modules de refroidissement 14a et 14b sont reliés en parallèle au circuit de refroidissement 10.

Les deux modules de refroidissement 14a et 14b sont identiques.

Chaque module de refroidissement 14a, 14b comporte un circuit hydraulique secondaire 15a, 15b apte à recevoir le fluide caloporteur. Le circuit hydraulique secondaire 15a, 15b comporte une entrée 18a, 18b reliée à la sortie 12 du circuit de refroidissement 10 et une sortie 19a, 19b reliée à l'entrée 11 du circuit de refroidissement 10.

L'entrée 18a, 18b de chaque circuit hydraulique secondaire 15a, 15b est reliée à la sortie 12 du circuit de refroidissement par l'intermédiaire de connecteurs 50a, 50b rapides anti-goutte à face plane.

De même, la sortie 19a, 19b de chaque circuit hydraulique secondaire 15a, 15b est reliée à l'entrée 11 du circuit de refroidissement par l'intermédiaire de connecteurs 50a, 50b rapides anti-goutte à face plane.

Chaque module de refroidissement 14a, 14b comporte également un échangeur de chaleur 20a, 20b apte à refroidir le fluide caloporteur du circuit hydraulique secondaire 15a, 15b. Pour cela, l'échangeur de chaleur 20a, 20b est de préférence un échangeur à plaque traversé par le circuit hydraulique secondaire 15a, 15b et par un circuit primaire 21a, 21b, lié au réseau du client, dans laquelle circule un fluide caloporteur.

Le circuit primaire 21a, 21b de chaque module de refroidissement est de préférence relié au réseau du client par l'intermédiaire de connecteurs 51a, 51b rapides anti-goutte à face plane.

Le fluide caloporteur qui circule dans la canalisation 21a, 21b est de préférence de l'eau. Le fluide caloporteur qui circule dans le circuit primaire 21a, 21b circule de préférence en sens inverse du fluide caloporteur qui circule dans le circuit hydraulique secondaire 15a, 15b. Le fluide caloporteur qui circule dans le circuit primaire 21a, 21b est de préférence contrôlé en débit par une vanne 29a, 29b, elle-même contrôlée par les moyens de commande 23a, 23b de chaque module de refroidissement.

Chaque module de refroidissement 14a, 14b comporte également une pompe 22a, 22a permettant de faire circuler le fluide caloporteur dans le circuit hydraulique secondaire et donc dans le circuit de refroidissement auquel il est relié. La pompe présente de préférence une puissance suffisante pour faire circuler le fluide caloporteur à une pression différentielle d'environ 3 bars à un débit de 75 l/min.

Chaque module de refroidissement 14a, 14b comporte également des moyens de commande 23a, 23b aptes à commander la pompe notamment.

Chaque module de commande 14a, 14b comporte également des moyens de mesure de la température 24a du fluide caloporteur dans le circuit hydraulique secondaire. Ces moyens de mesure de la température 24a comportent de préférence trois capteurs de température placés en sortie du circuit hydraulique secondaire de façon à réaliser trois mesures de la température T₀₋₁, T₁₋₁, T₂₋₁, respectivement T₀₋₂, T₁₋₂, T₂₋₂, du fluide caloporteur en sortie du circuit hydraulique secondaire. Les moyens de mesure de la température 24a du fluide caloporteur en sortie du circuit hydraulique secondaire sont reliés aux moyens de commande 23a, 23b du module de refroidissement auquel ils appartiennent. Le fait de mesurer la température du fluide caloporteur en sortie du circuit hydraulique secondaire permet de contrôler le débit de fluide circulant dans le circuit primaire 21a, 21b à travers l'échangeur 20a, 20b, et via le contrôle de la vanne 29a, 29b, de façon à ce que la température du fluide caloporteur en sortie du circuit hydraulique secondaire soit constante égale à une valeur seuil. Le débit du fluide caloporteur dans le circuit de refroidissement secondaire est de préférence contrôlé de façon à ce que le fluide caloporteur présente une température constante comprise entre 16°C et 40°C. Le fait d'avoir trois capteursde températures permet d'effectuer des mesures de températures redondantes et donc d'avoir une grande fiabilité pour ces mesures. On détecte ainsi très facilement si un des capteurs ne fonctionne pas.

Chaque module de refroidissement 14a, 14b comporte au moins un premier capteur de pression 25a, 25b, les moyens de commande 23a, 23b de chaque module de refroidissement 14a, 14b étant reliés aux deux premiers capteurs de pression 25a, 25b de chacun des deux modules de refroidissement 14a, 14b. Le premier capteur de pression 25a, 25b de chaque module de refroidissement est situé en entrée de la pompe dudit module de refroidissement.

Chaque module de refroidissement 14a, 14b comporte au moins un second capteur de pression 252a, 252b situé en sortie dudit module de refroidissement, la différence entre la mesure du capteur de pression 252a, 252b et la mesure du capteur de pression 25a, 25b étant reliés aux moyens de commande du module de refroidissement, c'est-à-dire que le moyen de commande du module de refroidissement traite, dans son programme de régulation, la donnée « différence de pression entre la sortie et l'entrée dudit module de refroidissement », telle qu'elle a été mesurée par les deux capteurs sortie et entrée du module, et non individuellement chacune des mesures de ces deux capteurs prises séparément.

Chaque module de refroidissement 14a, 14b comporte en outre de préférence un troisième capteur de pression (P₂₋₁) 26a, 26b en sortie de la pompe dudit module de refroidissement. Ce troisième capteur de pression 26a, 26b permet de vérifier que la pompe fonctionne correctement dans le cas d'un module actif, et permet de vérifier la mesure de pression dans le cas d'un module inactif en comparant cette pression avec la pression P₀₋₂ de l'autre module, actif.

En outre, les moyens de mesure de la pression en sortie de la pompe 26a, 26b sont reliés aux moyens de commande 23a, 23b du module de refroidissement auquel ils appartiennent.

Le débit du fluide caloporteur dans le circuit hydraulique secondaire de chaque module de refroidissement est commandé par les moyens de commandes 23a, 23b dudit module de refroidissement de façon à ce que le débit à travers chaque lame de calcul 3 soit constant. Pour cela, les moyens de commande commandent de préférence la vanne de régulation 28a, 28b du bypass ou voie de contournement de façon à ce que la différence de pression entre la sortie et l'entrée du module de refroidissement soit constante égale à une valeur seuil..

En outre, le fluide caloporteur est de préférence sous pression, dans le circuit hydraulique secondaire et dans le circuit de refroidissement, à une pression statique suffisamment élevée pour protéger la pompe de tout risque de cavitation. Cette pression statique est de préférence supérieure ou égale à 2 bars, et de manière plus préférentielle égale à 2.5 bars.

Chaque module de refroidissement 14a, 14b comporte également une voie de contournement ou bypass 27a, 27b disposée aux bornes de la pompe 22a, 22b et qui permet de faire contourner à une partie du fluide caloporteur la pompe. La quantité de fluide caloporteur qui est dévié dans la voie de contournement 27a, 27b est dosée par une vanne de régulation 28a, 28b qui est contrôlée par les moyens de commande.

L'armoire informatique comporte également une unité de commande centrale qui est reliée aux moyens de commande 23a, 23b des deux modules de refroidissement.

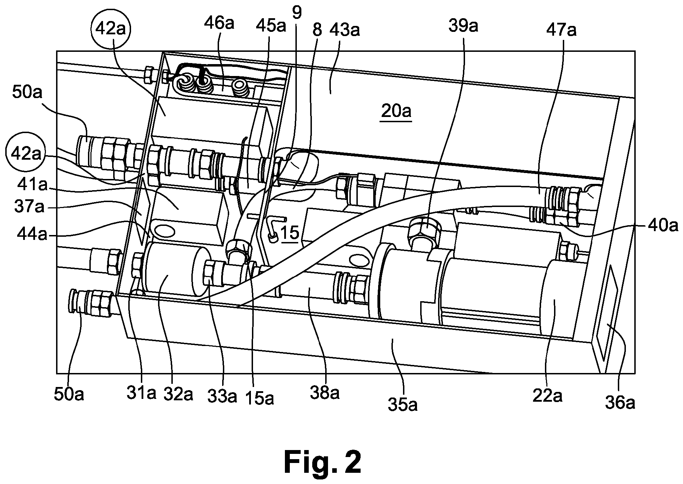

Un module de refroidissement 14a est représenté plus précisément sur les figures 2 à 3. L'autre module de refroidissement 14b est identique à celui représenté.

Le circuit hydraulique 15a du module de refroidissement 14a comporte un tuyau amont 31a aligné avec l'axe de la pompe 22a, ce qui permet un écoulement régulier du fluide dans le circuit hydraulique. Plus généralement, le module de refroidissement débite le fluide caloporteur à des vitesses linéaires de fluide constantes sans fluctuations de pression génératrices de pertes de charge et de vibrations grâce à la forme des tuyaux du circuit hydraulique.

Le module de refroidissement 14a comporte également un filtre 32a aligné avec le tuyau amont pour minimiser la perte de charge. Ce filtre est de préférence un filtre de 250 microns, disposé en amont de la pompe 15a pour la protéger, aligné avec l'axe de la pompe pour avoir un écoulement régulier la protégeant de tout risque de cavitation.

Le module de refroidissement 14a comporte également un té compact 33a à la sortie du by-pass pour mélanger le fluide caloporteur venant du by-pass 27a avec l'écoulement principal de fluide caloporteur. Ce té compact, ou raccord cinq voies, ne présente pas de changement de section trop important dans le raccord. Le capteur de pression 26a permettant de mesurer la pression en sortie de la pompe est monté en piquage perpendiculairement à l'écoulement et sans protrusion dans la canalisation pour minimiser l'erreur de mesure. Le mélange entre le fluide caloporteur venant du by-pass 27a et l'écoulement principal de fluide caloporteur est favorisé grâce à l'égalité des sections des 3 conduits. Un capteur de température additionnelle 34a permet de mesurer la température du fluide caloporteur en sortie de la pompe T₃₋₁, et ainsi additionner un moyen de contrôle supplémentaire, notamment en guise de protection thermique de la pompe dans le cas accidentelle d'une circulation exclusivement à travers le bypass.

Le module de refroidissement comporte une armature 35a percée par une grille avant 36a et deux grilles arrières 37a pour permettre à l'air de traverser le module de refroidissement.

La pompe 22a est placée près de la grille avant 36a, son ventilateur aspirant de l'air frais venant de l'extérieur par une grille avec un guide d'air pour empêcher de réaspirer de l'air chaud ayant déjà passé dans le module de refroidissement, ce qui évite la recirculation de l'air chaud.

En outre, l'axe de la pompe 22a est aligné avec le tuyau amont 31a pour avoir une alimentation régulière de la pompe 22a.

On utilise un tuyau souple 38a pour raccorder la pompe 22a au circuit hydraulique, ce qui permet de compenser les défauts d'alignement et permet le démontage de la pompe pour la maintenance.

Le module de refroidissement 22a comporte également un bloc foré 39a en aval de la pompe 22a:
- pas de changement de section trop important dans le bloc,
- capteur de pression monté perpendiculairement à l'écoulement pour minimiser l'erreur de mesure,
- séparation en 2 écoulements sans perturbation grâce à l'égalité des sections des 3 conduits.

Le module de refroidissement 14a comporte un coude en sortie et en entrée d'échangeur pour minimiser l'encombrement.

Le module de refroidissement comporte également un coude à grand rayon de courbure pour minimiser la perte de charge et ne pas perturber l'écoulement dans le by-pass.

Le module de refroidissement 14a comporte également un clapet anti-retour 40a près de l'échangeur pour créer un bloc démontable et de façon à ce que l'écoulement en provenance de l'autre module hydraulique n'entre pas dans celui-ci lorsque sa pompe est arrêtée.

Le module de refroidissement 14a comporte également des connecteurs rapides anti-goutte 50a à face plane permettant de démonter facilement un des modules de refroidissement en cas de pannes ou de maintenance, sans avoir à arrêter le refroidissement de l'armoire informatique. Dans le cas de maintenance, le démontage du module de refroidissement 14a est facilité par un système de déconnexion hydraulique rapide, tant au niveau de la connexion au réseau hydraulique de l'armoire 17, qu'au niveau de sa connexion au réseau d'eau du client. Cette modularité est possible grâce à des connecteurs rapides anti-goutte à face plane. Ainsi, chaque module de refroidissement est équipé de deux paires de connecteurs rapides 50a, 51a (une paire 50a correspondant à l'entrée et la sortie reliées au circuit de refroidissement de l'armoire et une paire 51a correspondant à l'entrée et la sortie reliée au réseau hydraulique client). Les deux connecteurs rapides en liaisons avec le circuit de refroidissement de l'armoire 17 sont positionnés à l'extrémité de chacun des flexibles entrée / sortie 15a, et s'accouplent aux connecteurs rapides complémentaires positionnés au niveau de l'entrée 19a de la rampe de distribution d'entrée 7 et au niveau de la sortie 18a de la rampe de distribution de sortie 8. Les deux connecteurs rapides en liaisons avec le réseau hydraulique client sont positionnés directement sur la façade du module de refroidissement.

Le module de refroidissement comporte des vannes à boisseau sphérique proportionnelle 41a, comprenant un dispositif de réglage de la section de passage favorisant la linéarité de la réponse en débit en fonction de l'angle d'ouverture, avec un servo-moteur monté couché pour minimiser l'encombrement, avec une commande électrique permettant une ouverture précise et une relecture précise de l'ouverture, contrairement à une électro-vanne proportionnelle.

Les traversées de cloison 42a du circuit hydraulique ou des canalisations de refroidissement à travers les cloisons de l'armature 35a sont compactes sans changement de section de façon à minimiser la perte de charge.

Les deux grilles 37a en face arrière du module, dont la somme de la surface d'ouverture est proche de celle de la grille placée en face avant 36a : une en aval de la vanne de régulation de température et l'autre en aval de la carte de régulation électronique.

Les moyens de commande 23a comporte une carte de régulation électronique centralisée 42a, placé dans un logement coulissant du module de refroidissement pour être démontable en maintenance, refroidie par l'écoulement d'air créé par le ventilateur de la pompe 22a, avec de faibles tensions continues, protégée des projections éventuelles lors de fuites accidentelles sur les tuyaux.

En outre, le module de refroidissement comporte des espaces entre les composants du module suffisants pour favoriser le passage de l'air de refroidissement entre les grilles avant et arrière, écoulement créé par le ventilateur de la pompe.

L'échangeur à plaques 20a, à flux croisés, est en cuivre pour de meilleures performances d'échange thermique, compact, et il est couché sur le côté pour minimiser l'encombrement.

En outre, l'échangeur de chaleur est isolé, tout comme les tuyaux du circuit hydraulique primaire 15a lié au réseau hydraulique client pour permettre l'utilisation d'eau froide, à une température inférieure à la température de rosée de la salle, ce qui évite un système de surveillance de la condensation.

Le module de refroidissement comporte également un détecteur de fuite 44a placé près du tuyau d'évacuation. Le fond de l'armature du module de refroidissement est est étanche et permet d'accueillir une grande quantité de liquide en cas de fuite : par conséquent, la fuite n'est détecté que si elle est importante, les petites fuites ne sont volontairement pas prises en compte.

Les moyens d'alimentation de la pompe 46a sont contenus dans un boitier étanche pour les tensions élevées d'alimentation de la pompe, en courant alternatif, abritant le relais de la pompe.

Les modules de refroidissement sont contrôlés par l'unité de commande de façon à ce qu'un des modules de refroidissement soit actif pendant que l'autre module de refroidissement est passif. Le module de refroidissement actif est relié au circuit de refroidissement de façon à ce que le circuit hydraulique secondaire de ce module de refroidissement soit relié au circuit de refroidissement de l'armoire. Ainsi, le module de refroidissement actif contrôle la différence de pression entre la sortie et l'entrée du module de refroidissement, à une pression différentielle seuil, de façon à ce que par conséquent, au sein du circuit de refroidissement de l'armoire, le débit de fluide caloporteur à travers chaque lame de calcul soit constant quelque soit le nombre de serveurs refroidis.

En cas de panne du module de refroidissement actif, ou en cas de maintenance, l'unité de commande active l'autre module de refroidissement de façon à ce qu'il devienne actif. Le module de refroidissement à réparer peut ainsi être démonté sans avoir à arrêter le refroidissement de l'armoire informatique. Le changement du module de refroidissement actif peut aussi être programmé pour vérifier la disponibilité du module de refroidissement.

Ainsi, l'armoire comporte toujours au moins un module de refroidissement actif qui assure la circulation du fluide caloporteur dans le circuit de refroidissement interne.

## Revendications

1. Armoire informatique (1) comportant :
- au moins un serveur montable sur bâti (2), le serveur montable sur bâti (2) étant traversé par un circuit de refroidissement (10), le circuit de refroidissement (10) étant parcouru par un fluide caloporteur, le circuit de refroidissement (10) comportant une entrée (11) et une sortie (12);
- des moyens d'alimentation (13) du circuit de refroidissement en fluide caloporteur, les moyens d'alimentation comportant :
- deux modules de refroidissement (14a, 14b), chaque module de refroidissement (14a, 14b) comportant :
• Un circuit hydraulique primaire (21a, 21b) comportant une sortie apte à être reliée à l'entrée d'un réseau hydraulique client et une entrée apte à être reliée à la sortie du réseau hydraulique client ;
• Un circuit hydraulique secondaire (15a, 15b) comportant une sortie (19a, 19b) reliée à l'entrée (11) du circuit de refroidissement (10) et une entrée (18a, 18b) reliée à la sortie (12) du circuit de refroidissement de l'armoire (10)
• Un échangeur de chaleur (20a, 20b) apte à refroidir le fluide caloporteur traversant le circuit hydraulique secondaire (15a, 15b) par dissipation de chaleur à travers le circuit hydraulique primaire (21a, 21b);
• Une pompe (22a, 22b) apte à contrôler le débit du fluide caloporteur dans le circuit hydraulique secondaire (15a, 15b);
• Des moyens de commande (23a, 23b) aptes à commander la pompe (22a, 22b);
- Une unité centrale de commande reliée aux moyens de commande (23a, 23b) de chacun des modules de refroidissement (14a, 14b);
**caractérisée en ce que** l'unité centrale de commande est apte à activer un des modules de refroidissement (14a, 14b) pendant que l'autre module de refroidissement (14a, 14b) est inactif, le circuit hydraulique secondaire (15a, 15b) du module de refroidissement actif alimentant le circuit de refroidissement (10) de façon à maintenir le fluide caloporteur à une pression différentielle constante entre la sortie et l'entrée du module de refroidissement.

2. Armoire informatique selon la revendication précédente, dans laquelle les circuits hydrauliques secondaires (15a, 15b) des modules de refroidissement (14a, 14b) sont reliés en parallèle.

3. Armoire informatique (1) selon l'une des revendications précédentes, dans laquelle les deux modules de refroidissement (14a, 14b) sont placés dans une partie inférieure (16) de l'armoire, le serveur montable sur bâti (2) étant placé dans une partie supérieure (17).

4. Armoire informatique (1) selon l'une des revendications précédentes, dans laquelle le fluide caloporteur dans le circuit de refroidissement présente une pression statique supérieure ou égale à 2 bars.

5. Armoire informatique (1) selon l'une des revendications précédentes, dans laquelle chaque module de refroidissement (14a, 14b) comporte en outre au moins un capteur de température (24a, 24b) apte à mesurer la température en sortie du circuit hydraulique secondaire (15a, 15b) dudit module de refroidissement, le débit du fluide caloporteur du circuit hydraulique primaire étant maintenu à un débit choisi pour que la température en sortie du circuit hydraulique secondaire soit égale à une température seuil.

6. Armoire informatique selon l'une des revendications précédentes, dans laquelle chaque module de refroidissement comporte en outre une voie de contournement (27a, 27b) agencée pour permettre à au moins une partie du fluide caloporteur de contourner la pompe (22a, 22b).

7. Armoire informatique selon l'une des revendications précédentes, dans laquelle le circuit hydraulique secondaire (15a, 15b) de chaque module de refroidissement (14a, 14b) comporte un clapet anti-retour (40a, 40b) en amont de l'échangeur (20a, 20b).

8. Armoire informatique selon l'une des revendications précédentes, dans laquelle chaque module de refroidissement (14a, 14b) comporte au moins un premier capteur de pression (25a, 25b), les moyens de commande (23a, 23b) de chaque module de refroidissement (14a, 14b) étant reliés aux deux premiers capteurs de pression (25a, 25b) de chacun des deux modules de refroidissement (14a, 14b).

9. Armoire informatique (1) selon l'une des revendications précédentes, dans laquelle le premier capteur de pression (25a, 25b) de chaque module de refroidissement est situé en entrée de la pompe dudit module de refroidissement.

10. Armoire informatique (1) selon l'une des revendications précédentes, dans laquelle chaque module de refroidissement (14a, 14b) comporte au moins un troisième capteur de pression (26a, 26b) situé en sortie de la pompe dudit module de refroidissement.

11. Armoire informatique (1) selon l'une des revendications précédentes, dans laquelle l'entrée et la sortie du circuit hydraulique primaire de chaque module de refroidissement sont pourvus de connecteurs rapides anti-gouttes (51a, 51b) aptes à connecter le circuit hydraulique primaire au réseau hydraulique client, l'entrée et la sortie du circuit hydraulique secondaire de chaque module de refroidissement étant pourvus de connecteurs rapides anti-goutte (50a, 50b) aptes à connecter le circuit hydraulique secondaire au circuit de refroidissement.

## Patentansprüche

1. IT-Schrank (1), bestehend aus:
- mindestens einem in ein Traggestell (2) montierbaren Server, wobei der in ein Traggestell montierbare Server (2) von einem Kühlkreislauf (10) gekühlt, der Kühlkreislauf (10) von einer Wärmeträgerflüssigkeit durchströmt wird, und der Kühlkreislauf (10) aus einem Eingang (11) und einem Ausgang (12) besteht;
- Einrichtungen (13) des Kühlkreislaufes zur Versorgung mit der Wärmeträgerflüssigkeit, wobei die Versorgungseinrichtungen aus folgenden Elementen bestehen;
- zwei Kühlungsmodulen (14a, 14b), wobei jedes Kühlungsmodul aus folgenden Elementen besteht:
• einem primären Hydraulikkreislauf (21a, 21b) mit einem Ausgang, der für die Verbindung mit dem Eingang eines Kunden-Hydrauliknetzes geeignet ist und einem Eingang, der für die Verbindung mit dem Ausgang des Kunden-Hydrauliknetzes geeignet ist;
• einem sekundären Hydraulikkreislauf (15a, 15b) mit einem Ausgang (19a, 19b), der mit dem Eingang (11) des Kühlkreislaufes (10) verbunden ist und einem Eingang (18a, 18b), der mit dem Ausgang (12) des Kühlkreislaufes (10) des IT-Schrankes verbunden ist.
• einem Wärmetauscher (20a, 20b), der in der Lage ist die Wärmeträgerflüssigkeit, die durch den sekundären Hydraulikkreislauf strömt (15a, 15b) mittels Wärmeableitung über den primären Hydraulikkreislauf (21a, 21b) zu kühlen;
• einer Pumpe (22a, 22b), die in der Lage ist, den Durchfluss der Wärmeträgerflüssigkeit im sekundären Hydraulikkreislauf (15a, 15b) zu steuern;
• Schalteinrichtungen (23a, 23b), die in der Lage sind, die Pumpe (22a, 22b) zu steuern;
- einer Zentralsteuereinheit, die mit den Schalteinrichtungen (23a, 23b) jedes einzelnen Kühlungsmoduls (14a, 14b) verbunden ist;
**dadurch gekennzeichnet, dass** die Zentralsteuereinheit in der Lage ist, eines der beiden Kühlungsmodule (14a, 14b) zu aktivieren, wohingegen sich das andere Kühlungsmodul (14a, 14b) im inaktiven Zustand befindet, wobei der sekundäre Hydraulikkreislauf (15a, 15b) des aktivierten Kühlungsmoduls den Kühlungskreislauf (10) so mit Wärmeträgerflüssigkeit versorgt, dass diese auf einem konstanten Differentialdruck zwischen dem Ausgang und dem Eingang des Kühlungsmoduls gehalten wird.

2. IT-Schrank (1) gemäß vorherigem Patentanspruch, in dem die sekundären Hydraulikkreisläufe (15a, 15b) der Kühlungsmodule (14a, 14b) parallel geschaltet sind.

3. IT-Schrank(1) gemäß einem der vorherigen Patentansprüche, in dem die zwei Kühlungsmodule (14a, 14b) in einem unteren Teil (16) des Schrankes untergebracht sind und der in ein Traggestell montierbare Server (2) in einem oberen Teil (17) untergebracht ist.

4. IT-Schrank (1) gemäß einem der vorherigen Patentanspüche, in dem der statische Druck der Wärmeträgerflüssigkeit im Kühlungskreislauf ≥ 2 bar beträgt:

5. IT-Schrank (1) gemäß einem der vorherigen Patentansprüche, in dem darüber hinaus jedes Kühlungsmodul (14a, 14b) mindestens über einen Temperatursensor (24a, 24b) verfügt, der in der Lage ist, die Temperatur am Ausgang des sekundären Hydraulikkreislaufs (15a, 15b) im besagten Kühlungsmodul zu messen, wobei der Durchfluss der Wärmeträgerflüssigkeit im primären Hydraulikkreislauf auf einem bestimmten Durchflussniveau gehalten wird, damit die Temperatur am Ausgang des sekundären Hydraulikkreislaufs einer Schwellentemperatur entspricht.

6. IT-Schrank gemäß einem der vorherigen Patentansprüche, in dem jedes Kühlungsmodul darüber hinaus über eine Bypass-Leitung (27a, 27b) verfügt, die so angeordnet ist, dass sie es mindestens einem Teil der Wärmeträgerflüssigkeit ermöglicht, die Pumpe (22a, 22b) zu umgehen.

7. IT-Schrank gemäß einem der vorherigen Patentansprüche, in dem der sekundäre Hydraulikkreislauf (15a, 15b) jedes einzelnen Kühlungsmoduls (14a, 14b) oberhalb des Wärmetauschers (20a, 20b) über ein Rückschlagventil verfügt.

8. IT-Schrank (1) gemäß einem der vorherigen Patentansprüche, in dem jedes Kühlungsmodul (14a, 14b) mindestens über einen ersten Drucksensor (25a, 25b) verfügt, wobei die Schalteinrichtungen (23a, 23b) jedes einzelnen Kühlungsmoduls (14, 14b) mit den ersten beiden Drucksensoren (25a, 25b) jedes einzelnen der beiden Kühlungsmodule (14 a, 14b) verbunden sind.

9. IT-Schrank (1) gemäß einem der vorherigen Patenansprüche, in dem der erste Drucksensor (25a, 25b) jedes einzelnen Kühlungsmoduls sich am Eingang der Pumpe des besagten Kühlungsmoduls befindet.

10. IT-Schrank (1) gemäß einem der vorherigen Patentansprüche, in dem jedes Kühlungsmodul (14a, 14b) mindestens über einen dritten Drucksensor (26a, 26b) am Ausgang der Pumpe des besagten Kühlungsmoduls verfügt.

11. IT-Schrank (1) gemäß einem der vorherigen Patentansprüche, in dem der Eingang und der Ausgang des primären Hydraulikkreislaufs jedes einzelnen Kühlungsmoduls mit leckfreien Schnellverbindern (51a, 51b) ausgestattet sind, die in der Lage sind, den primären Hydraulikkreislauf mit dem Kunden-Hydrauliknetz zu verbinden, wobei der Eingang und der Ausgang des sekundären Hydraulikkreislaufs jedes einzelnen Kühlungsmoduls mit leckfreien Schnellverbindern ausgestattet ist (50a, 50b), die in der Lage sind, den sekundären Hydraulikkreislauf mit dem Kühlungskreislauf zu verbinden.

## Claims

1. Computer cabinet (1) comprising:
- at least one server can be mounted on a frame (2), with the server that can be mounted on a frame (2) being passed through by a cooling circuit (10), with the cooling circuit (10) being travelled through by a coolant, the cooling circuit (10) comprising an inlet (11) and an outlet (12);
- means of supplying (13) the cooling circuit with coolant, with the means of supplying comprising:
- two cooling modules (14a, 14b), with each cooling module (14a, 14b) comprising:
∘ A primary hydraulic circuit (21a, 21b) comprising an outlet able to be connected to the inlet of a client hydraulic network and an inlet able to be connected to the outlet of the client hydraulic network;
∘ A secondary hydraulic circuit (15a, 15b) comprising an outlet (19a, 19b) connected to the inlet (11) of the cooling circuit (10) and an inlet (18a, 18b) connected to the outlet (12) of the cooling circuit of the cabinet (10)
∘ A heat exchanger (20a, 20b) able to cool the coolant passing through the secondary hydraulic circuit (15a, 15b) via dissipation of heat through the primary hydraulic circuit (21a, 21b);
∘ A pump (22a, 22b) able to control the flow rate of the coolant in the secondary hydraulic circuit (15a, 15b);
∘ Controllers (23a, 23b) able to control the pump (22a, 22b);
- A central control unit connected to the controllers (23a, 23b) of each one of the cooling modules (14a, 14b);
**characterised in that** the central control unit is able to activate one of the cooling modules (14a, 14b) while the other cooling module (14a, 14b) is inactive, with the secondary hydraulic circuit (15a, 15b) of the active cooling module supplying the cooling circuit (10) in such a way as to keep the coolant at a constant differential pressure between the outlet and the inlet of the cooling module.

2. Computer cabinet as claimed in the preceding claim, wherein the secondary hydraulic circuits (15a, 15b) of the cooling modules (14a, 14b) are connected in parallel.

3. Computer cabinet (1) according to one of the preceding claims, wherein the two cooling modules (14a, 14b) are placed in a lower portion (16) of the cabinet, with the server that can be mounted on a frame (2) being placed in an upper portion (17).

4. Computer cabinet (1) according to one of the preceding claims, wherein the coolant in the cooling circuit has a static pressure greater than or equal to 2 bars.

5. Computer cabinet (1) according to one of the preceding claims, wherein each cooling module (14a, 14b) further comprises at least one temperature sensor (24a, 24b) able to measure the temperature at the outlet of the secondary hydraulic circuit (15a, 15b) of said cooling module, with the flow rate of the coolant of the primary hydraulic circuit being kept at a flow rate chosen so that the temperature at the outlet of the secondary hydraulic circuit is equal to a threshold temperature.

6. Computer cabinet according to one of the preceding claims, wherein each cooling module further comprises a bypass (27a, 27b) arranged to allow at least one portion of the coolant to circumvent the pump (22a, 22b).

7. Computer cabinet according to one of the preceding claims, wherein the secondary hydraulic circuit (15a, 15b) of each cooling module (14a, 14b) comprises a check valve (40a, 40b) upstream of the exchanger (20a, 20b).

8. Computer cabinet according to one of the preceding claims, wherein each cooling module (14a, 14b) comprises at least one first pressure sensor (25a, 25b), with the controllers (23a, 23b) of each cooling module (14a, 14b) being connected to the first two sensor pressures (25a, 25b) of each one of the two cooling modules (14a, 14b).

9. Computer cabinet (1) according to one of the preceding claims, wherein the first pressure sensor (25a, 25b) of each cooling module is located at the inlet of the pump of said cooling module.

10. Computer cabinet (1) according to one of the preceding claims, wherein each cooling module (14a, 14b) comprises at least one third pressure sensor (26a, 26b) located at the outlet of the pump of said cooling module.

11. Computer cabinet (1) according to one of the preceding claims, wherein the inlet and the outlet of the primary hydraulic circuit of each cooling module are provided with anti-drip quick connectors (51a, 51b) able to connect the primary hydraulic circuit to the client hydraulic network, with the inlet and the outlet of the secondary hydraulic circuit of each cooling module being provided with anti-drip quick connectors (50a, 50b) able to connect the secondary hydraulic circuit to the cooling circuit.
